(19) Europäisches Patentamt / European Patent Office / Office européen des brevets

(11) **EP 3 902 022 B1**

(12) **EUROPÄISCHE PATENTSCHRIFT**

(45) Veröffentlichungstag und Bekanntmachung des Hinweises auf die Patenterteilung:
28.09.2022 Patentblatt 2022/39

(21) Anmeldenummer: **21167957.6**

(22) Anmeldetag: **13.04.2021**

(51) Internationale Patentklassifikation (IPC):
*H01L 41/053* (2006.01)   *F16K 31/00* (2006.01)
*H01L 41/09* (2006.01)   *H01L 41/04* (2006.01)

(52) Gemeinsame Patentklassifikation (CPC):
**H01L 41/053; B41J 2/04505; B41J 2/04581;**
**B41J 2/1614; B41J 2/1623; B41J 2/1632;**
**F16K 31/006; H01L 41/094; H01L 41/25**

(54) **PIEZOAKTUATOR UND PIEZOAKTUATOR-ARRAY**

PIEZO ACTUATOR AND PIEZO ACTUATOR ARRAY

PIÉZOACTIONNEUR ET RÉSEAU DE PIÉZOACTIONNEURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.04.2020 DE 102020002403**

(43) Veröffentlichungstag der Anmeldung:
**27.10.2021 Patentblatt 2021/43**

(73) Patentinhaber: **EXEL Industries S.A.**
**51200 Epernay (FR)**

(72) Erfinder: **Büstgens, Burkhard**
**79194 Gundelfingen (DE)**

(74) Vertreter: **Keenway Patentanwälte Neumann Heine Taruttis**
**PartG mbB**
**Postfach 10 33 63**
**40024 Düsseldorf (DE)**

(56) Entgegenhaltungen:
**WO-A1-03/016762    DE-A1-102009 033 780**
**GB-A- 2 233 766**

## Beschreibung

Die Erfindung betrifft einen einzelnen Piezo-Biegewandler, ferner Array-Anordnungen von Piezo-Biegewandlern, sogenannte Piezo-Biegewandler-Arrays und ihre Anwendungen, insbesondere Mikroventile und Mikroventil-Arrays.

Erfindungsgemäße Piezo-Biegewandler-Arrays finden insbesondere Verwendung zur Aktuierung von Mikro-Fluidventil-Arrays in vielkanaligen Druckköpfen oder Beschichtungsköpfen mit ein oder mehreren Reihen aus individuell oder gruppiert steuerbaren Abgabedüsen, welche Flüssigkeitstropfen oder Flüssigkeitsstrahlen auf Oberflächen abgeben zum Zwecke einer farblichen Dekoration oder zur randscharfen, sprühnebelfreien, digital gesteuerten Aufbringung ein oder mehrerer Schichten aus einem flüssigen Beschichtungsmittel wie beispielsweise einer Farbe, einem Lack, einem Kleb- oder Dichtstoff, oder für funktionale Beschichtungen von Bauteilen.

Verwendungsmöglichkeiten entsprechender Druckköpfe oder Beschichtungsköpfe sind gegeben im Bereich der Lackierung, der Abdichtung oder des Klebens von Fahrzeugen aller Art wie Kraftfahrzeugen, aber auch Flugzeugen und Schiffen, vornehmlich unter Einsatz von Industrierobotern (insbesondere Mehrachs-Knickarmrobotern) zur Bewegung der Druckköpfe oder Beschichtungsköpfe oder im Bereich der Beschichtung von Bauteilen jeglicher Art einschließlich Produkten aus der Verbrauchgüterindustrie mit flüssigen Beschichtungsmitteln, unter Einsatz von Industrierobotern oder kartesischen Robotern, oder integriert in Single-Pass Bedruckungsoder Beschichtungsanlagen, sowie im Bereich aller im Zusammenhang mit Gebäuden benötigten Beschichtungen.

Insbesondere finden vorgenannte Mikroventil-Arrays als mikropneumatische Pilotventil-Arrays in denjenigen Druckköpfen oder Beschichtungsköpfen der oben beschriebenen Art Verwendung, welche nach einem elektro-pneumatischen Arbeitsprinzip arbeiten, wie beispielsweise in EP 2 442 983 B1 beschrieben. Darin übernehmen die hier beschriebenen Komponenten Funktionen der in EP 2 442 983 B1 beschriebenen Komponenten des mikropneumatischen Schaltkreises und der Aktuatoren.

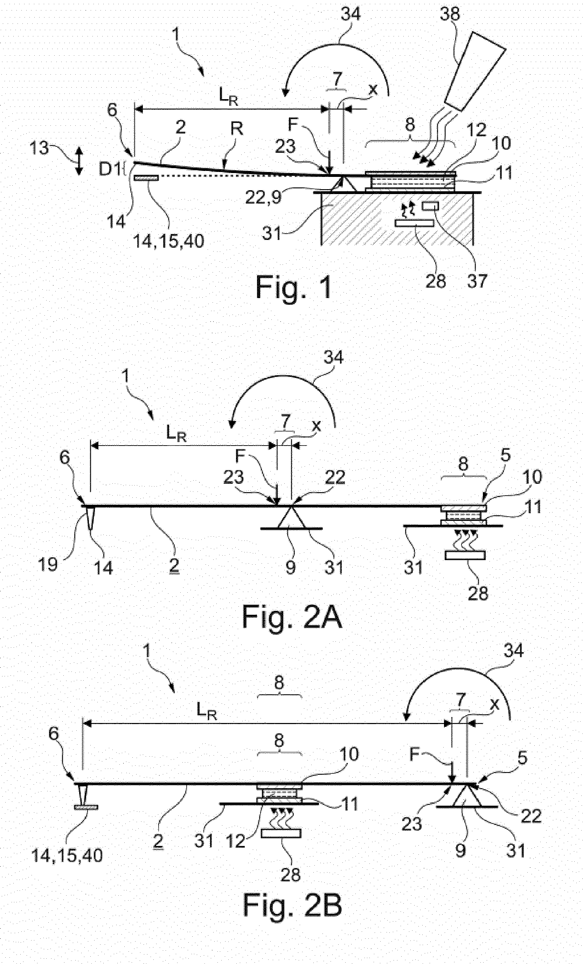

Hier betrachtete Piezo-Biegewandler aus dem Stand der Technik (vergleiche zum Beispiel Fig. 1) sind meist einseitig fest eingespannte Aktuatoren einer bestimmten Länge zur Erzeugung einer Stellbewegung senkrecht zur Längsrichtung an einem beweglichen Ende und sind überwiegend flach und aus mehreren Materialschichten mit mindestens einer piezoelektrischen Schicht aufgebaut. Aus der aus einer elektrischen Spannungsbeaufschlagung einer oder mehrerer piezoelektrischer Schichten resultierenden Längsdehnung ergibt sich infolge innerer Verspannung des Mehrlagenaufbaus eine Verbiegung des Biegewandlers senkrecht zur Längsrichtung mit im Vergleich zur Längsdehnung erheblich größerer Auslenkung. Diese wird für Stellaufgaben genutzt, indem der Piezo-Biegewandler entweder direkt an seinem ersten, beweglichen Ende oder über einen Effektor ein Stellelement beispielsweise eines Mikroventils bewegt. Die Auslenkung des Piezo-Biegewandlers nimmt mit dessen Länge zu, die Eigenfrequenz der ersten für Stellaufgaben genutzten Eigenmode und damit Kraft und Steifheit nehmen ab. Ziel der Auslegung eines Piezo-Biegewandlers ist dabei meist, dass Auslenkung, Kraft und die erste Eigenfrequenz möglichst hoch sind. Hier betrachtete Piezo-Biegewandler werden für einen Hub in der Größenordnung von 20 $\mu$m [Mikrometer], 50 $\mu$m, 100 $\mu$m, 200 $\mu$m oder höher ausgelegt bei einem Abstand zwischen benachbarten Piezo-Biegewandlern von 0,5 mm [Millimeter] bis beispielsweise 10 mm und mehr.

Wesentlich für einen definierten Betrieb ist eine stets unveränderliche ReferenzLage des beweglichen Endes des Piezo-Biegewandlers oder eines damit verbundenen Effektors bezüglich des Stellelementes des Mikroventils. Das Stellelement eines Mikroventils ist das bewegliche Element eines Ventils, beispielweise ein Schließelement, welches mit einer Ventilöffnung korrespondiert und mit diesem somit ein "Ventil" bildet, indem je nach der Position des Stellelementes die Ventilöffnung entweder verschlossen oder geöffnet wird. Aufgrund der oben genannten kleinen Auslenkungen im Zusammenhang mit Mikroventilen wirken sich unerwünschte Veränderungen wie mechanische Dehnungen, Verformungen oder Kriechprozesse, die mit der Zeit oder Temperatur-bedingt im Piezo-Biegewandler oder in dessen Peripherie einschließlich dem Gehäuse auftreten können, auf die Referenzlage, also auf den Abstand des Effektors zum Stellelement des Mikroventils aus. Durch eine veränderte Referenzlage wird die Funktion des Mikroventils verändert. Konventionelle Piezo-Biegewandler werden einseitig fest eingeklemmt, wie beispielsweise in Fig. 1A gezeigt, sodass diese Veränderungen auf Dauer nicht kompensierbar sind.

DE 10 2009 033 780 B4 schlägt als Lösung einen Piezo-Biegewandler für ein Pneumatikventil mit einer "schwimmenden Lagerung" oder Fluidlagerung vor. Zusammen mit einem über eine Feder aufgegebenen Bias-Moment, das den Piezo-Biegewandler gegen eine Referenzposition drückt, bietet die Fluidlagerung im statischen Fall keinen Widerstand, sodass langsam stattfindende Veränderungen kontinuierlich ausgeglichen werden. Durch Verwendung eines hochviskosen Lager-Fluids jedoch treffen schnelle Stellbewegungen auf einen Fluidwiderstand, sodass sich die Fluidlagerung diesen gegenüber wie ein festes Lager verhält. Nachteil der Verwendung einer Fluidlagerung ist jedoch, dass ein Betrieb mit statischen Auslenkungen nicht möglich ist, es ist ausschließlich für den Pulsbetrieb geeignet.

Neben dem Wunsch nach einer über die gesamte Lebensdauer hinweg unveränderlichen Stellfunktion unter den genannten schädlichen Einflüssen besteht weiterhin für die o.g. Anwendungen grundsätzlich der Wunsch nach hohen Arbeitsfrequenzen im Bereich von beispielsweise 500 Hz [Hertz], 1 kHz, 2kHz, 3kHz, 4kHz oder 5kHz, hoher Biegewandler-Auslenkung, hoher Haltekraft, niedriger elektrischer Betriebsspannung, geringen Unterschieden zwischen benachbarten Piezo-Biegewandlern und möglichst unbegrenzter Lebensdauer und einer kostengünstigen Massen-Herstellung der Piezo-Biegewandler-Arrays und Mikroventil-Arrays.

Aus der WO 03/016762 A1 ist ein piezoelektrisch betätigtes Fluidventil bekannt. Dieses kann insbesondere für eine elektrisch regelbare Kraftfahrzeugbremsanlage verwendet werden.

Aus der GB 2 233 766 A ist eine Vorrichtung bekannt, mit der insbesondere kleine Durchflussmengen gemessen werden können. Dabei kommt ein piezoelektrischer Transducer zum Einsatz.

Der Erfindung liegt insgesamt die Aufgabe zugrunde, leistungsfähige Piezo-Biegewandler eines Aktuator-Arrays für eine lange Betriebsdauer zu schaffen, insbesondere für die genannten Anwendungen.

Diese Aufgabe wird gelöst durch einen Piezoaktuator mit den Merkmalen des unabhängigen Anspruchs mit einem Piezo-Biegewandler und ein aus mindestens einer Reihe von Piezo-Biegewandlern zusammengesetztes Piezo-Biegewandler-Array.

Der erfindungsgemäße Piezoaktuator und das daraus zusammengesetzte Piezoaktuator-Array einschließlich der offenbarten Ausführungsformen ermöglichen einen andauernden Langzeitbetrieb.

Nach einem weiterhin beanspruchten Verfahren zur Ausrichtung eines Piezoaktors werden wiederholt automatisierte Ausrichtprozesse des Piezoaktuators in Bezug auf das Stellglied vorgenommen, um Stellelemente wie beispielsweise Schließelemente von Mikroventilen in stets reproduzierbarer Weise betätigen zu können. In einem Ausrichtprozess wird dabei der Piezoaktuator zum Beseitigen der vorgenannten unerwünschten Veränderungen in den Piezoelementen, Stellelementen, Mikroventilen oder im Bereich des Gehäuses stets wieder in seine Referenz- oder Ausgangsposition gegenüber dem Stellelement gebracht und dieser Zustand bis zum nächsten Ausrichtprozess eingefroren. In einem Ausrichtprozess wird dabei eine Zwischenschicht in einem Lagerbereich des Piezo-Biegewandlers kurzzeitig aufgeschmolzen und die Piezoelemente in einen definierten Ladungszustand versetzt. Mittels einer äußeren Kraft auf den Piezo-Biegewandler wird dieser mit seinem beweglichen Ende oder einem damit verbundenen Effektor gegen einen Referenzanschlag, beispielsweise das Schließelement eines Mikroventils, bewegt. Anschließend wird dieser Zustand durch Erstarren der Zwischenschicht eingefroren und der Piezoaktuator befindet sich wieder in seiner Referenzlage.

Es sei angemerkt, dass ein erfindungsgemäßer Ausrichtprozess in vielfacher Weise verwendet werden kann: beispielsweise erstmalig bei der Montage und/oder Inbetriebnahme eines Bauteils, insbesondere eines Druckkopfes, Beschichtungskopfes, Dosierkopfes, Dispensierkopfes, eines Flüssigkeitsventiles, oder eines Pneumatikventils, um nur wenige zu nennen; ferner in der Wartung, bei der Modifikation des Bauteils an eine neue Applikation, bei der Veränderung oder beim Austausch von Peripheriekomponenten sowie bei der Veränderung der Betriebsbedingungen einer bestehenden Konfiguration, beispielsweise durch Anpassen an eine veränderte Applikation oder Spezifikation; insbesondere im Falle eines Druckkopfes oder Beschichtungskopfes die Adaption an ein anderes oder verändertes Beschichtungsmittel oder an veränderte Betriebsparameter (Temperatur, Drücke..), Beschichtungsparameter (Schichtstärke, Applikationsgeschwindigkeit, Tropfenfrequenz, dem Wechseln zwischen Tropfen- und Strahlapplikation); ferner nach Veränderung der Position des Referenzanschlages oder wenn der mit dem Referenzanschlag assoziierte Ladungszustand der Piezoelemente des Piezoaktuators verändert werden soll. Zusammengefasst ist der erfindungsgemäße Ausrichtprozess in jeder Situation anzuwenden, wenn eine Referenzierung des Piezoaktuators bezüglich neuer oder veränderter Verhältnisse jedweder Art vorgenommen werden sollte.

Um vorgenannte Ausrichtprozesse zu ermöglichen, verfügt ein erfindungsgemäßer Piezoaktuator, welcher zur Durchführung einer Stellbewegung dient, über die erforderlichen Vorrichtungen und Mittel: Der Piezoaktuator weist dabei zunächst einen Piezo-Biegewandler aus einer Trägerschicht auf, die ein- oder zweiseitig mit einer Piezolamelle zumindest teilweise belegt ist, weiterhin ein bewegliches Ende zur Ausübung einer Stellbewegung und ein Gehäuse, in dem der Piezo-Biegewandler gelagert ist und mit dem ein Stellelement oder eine Stell-Applikation wie beispielsweise ein Mikroventil fest verbunden ist. Der erfindungsgemäße Piezoaktuator ist ferner gekennzeichnet durch einen Referenzanschlag, der mit dem Gehäuse verbunden ist, zur Festlegung einer Referenzposition für die Stellbewegung des Stellelementes oder der Stell-Applikation, ferner durch einen ersten Lagerbereich, der Bereiche des Aktuators und des Gehäuses umfasst und welcher Verdrehungen $\phi 1$ des Piezo-Biegewandlers ermöglicht, ferner durch einen zweiten Lagerbereich mit einer Biegewandler-seitigen Fläche und einer Gehäuse-seitigen Fläche und einer Zwischenschicht zwischen den Flächen, welches diese verbindet und welche (bei niedriger Temperatur) verflüssigbar ist und schließlich durch ein Andruckelement zur Erzeugung eines Bias-Drehmomentes auf den Piezo-Biegewandler um den ersten Lagerbereich gegen den Referenzanschlag.

Der erfindungsgemäße Piezoaktuator mit Piezo-Biegewandler und das entsprechende Piezo-Biegewandler-Array weisen somit zunächst in Übereinstimmung mit dem Stand der Technik aus DE 10 2009 033 780 B4 eine Trägerschicht auf, die einseitig ("monomorph") oder beidseitig ("bimorph") mit je einer Piezolamelle belegt ist, welche die Trägerschicht zumindest teilweise bedeckt/bedecken. Die Piezolamellen weisen ebenso die üblichen Metallisierungen auf, beispielsweise aus einer Silberhaltigen Dickschicht oder einem Dünnfilmaufbau. Weiterhin weist der Piezo-Biegewandler (und entsprechend das Piezo-Biegewandler-Array entsprechend) ein bewegliches Ende zur Durchführung einer Stellbewegung auf, weiterhin einen Referenzanschlag zur Festlegung einer Referenzposition für die Stellbewegung, welche mit dem beweglichen Ende des Piezo-Biegewandlers assoziiert ist, weiterhin einen ersten Lagerbereich, welcher so beschaffen ist, dass der Piezo-Biegewandler um diesen drehbar ist. Weiterhin einen zweiten Lagerbereich, welcher zwischen einer Biegewandlerseitigen Fläche und einer Gehäuse-seitigen Fläche eine Zwischenschicht enthält, weiterhin ein Andruck-Element im Bereich des ersten Lagerbereiches zur Erzeugung eines konstanten Bias-Drehmomentes auf den Piezo-Biegewandler um den ersten Lagerbereich, das so gerichtet ist, dass das bewegliche Ende des Piezo-Biegewandlers oder ein damit verbundener Effektor auf das Stellglied oder einen Referenzanschlag, der mit dem Mikro-Ventil assoziiert ist, drückt.

Anders als in DE 10 2009 033 780 B4 besteht die Zwischenschicht im zweiten Lagerbereich aus einem Feststoff, welcher jedoch temporär aufgeschmolzen werden kann (aufschmelzbar ist). In einem Betriebsmodus ist die Zwischenschicht im zweiten Lagerbereich in einem festen Aggregatzustand und verhält sich in unterschiedlichen bevorzugten Varianten entweder vorwiegend wie ein festes Lager oder vorwiegend wie ein drehbares Lager, somit wie ein Lager, das im Hinblick auf ein oder mehrere translatorische Freiheitsgrade, zumindest jedoch in der Richtung der Stellbewegung des Piezo-Biegewandlers fest ist. Damit erlaubt der Piezo-Biegewandler während des Betriebes gegenüber dem aus DE 10 2009 033 780 B4 auch stationäre Auslenkungen.

In einer ersten Lagerungsart LA1 unterstützt der zweite Lagerbereich, welcher stets die Zwischenschicht enthält, den Piezo-Biegewandler in einem größeren Bereich, so, dass sich dieser Lagerbereich bevorzugt in allen sechs Bewegungsfreiheitsgraden fest verhält, siehe Fig. 1. In einer zweiten Lagerungsart LA2 ist der zweite Lagerbereich eng begrenzt bzw. punktuell ausgeführt und befindet sich an dem beweglichen Ende des Piezo-Biegewandlers entgegengesetzten Ende des Piezo-Biegewandlers, siehe Figuren 2A - 2C.

Der Piezo-Biegewandler ist nun weiterhin gekennzeichnet durch einen Betriebsmodus und einen Ausrichtmodus, wobei im Betriebsmodus der Piezo-Biegewandler Stellbewegungen ausführt, die Temperatur der Zwischenschicht sich unterhalb ihrer Verflüssigungstemperatur befindet und die Zwischenschicht ausreichend fest ist, um die Lagerkräfte im zweiten Lagerbereich zu übertragen, und wobei im Ausrichtmodus der Piezo-Biegewandler an einen Referenzanschlag ausgerichtet wird, indem die Temperatur der Zwischenschicht aufgrund von Wärmezufuhr oberhalb ihrer Verflüssigungstemperatur liegt.

Im Ausricht-Modus werden ein oder mehrere Ausrichtprozesse durchgeführt, welche folgende Schritte enthalten: in austauschbarer Reihenfolge das Verflüssigen der Zwischenschicht des zweiten Lagerbereiches durch dessen Beheizung mittels einer Wärmequelle, oder, das Anlegen derjenigen elektrischen Spannungen an alle elektrischen Elektroden des Piezo-Biegewandlers, welche mit der Position des Referenzanschlages assoziiert werden sollen, in einem Folgeschritt die Ausrichtung des Piezo-Biegewandlers gegen den Referenzanschlag unter der Wirkung des Bias-Drehmomentes während der Dauer einer Ausrichtzeit $T_A$, und schließlich die Erstarrung der Zwischenschicht durch Abkühlung des zweiten Lagerbereiches während der Dauer einer Abkühlzeit $T_K$. Somit wird im Schritt des Erstarrens des Materials der Zwischenschicht die Lage der Biegewandler-seitigen Fläche und der Gehäuse-seitigen Fläche des zweiten Lagerbereiches zueinander zum Zeitpunkt des Erstarrens eingefroren.

Es sei angemerkt, dass vor dem Schritt des Erstarrens der Zwischenschicht für eine Ausrichtzeit $T_A$ im Bereich von beispielsweise 1/2 s [Sekunde], 1 s, 5 s, 10 s, 30 s oder 1 Minute lang gleichzeitig die Zwischenschicht in einem fließfähigen Zustand vorliegen muss und alle Elektroden des Piezo-Biegewandlers mit einer definierten elektrischen Spannung beaufschlagt sein müssen.

Der Piezo-Biegewandler führt während der Ausrichtzeit $T_A$ dann eine Drehung um den ersten Lagerbereich in positiver oder negativer Drehrichtung aus, wenn vor dem Ausrichtprozess eine Abweichung der Lage des Piezo-Biegewandler in Bezug auf dessen Ausrichtung bezüglich des Referenzanschlages vorlag. Während der Ausrichtung des Piezo-Biegewandlers in einem Ausrichtprozess verändert sich die Lage der Biegewandler-seitigen Fläche zur festen, mit dem Gehäuse assoziierten Fläche des zweiten Lagerbereiches und es kann verflüssigtes Material aus der Zwischenschicht in den Zwischenraum zwischen den Flächen einströmen oder ausströmen. Schließlich wird während des Erstarrens die Lage der beiden Flächen zueinander eingefroren und der Piezo-Biegewandler befindet sich in seiner Referenz-Ausrichtung.

Ein Ausrichtprozess kann als einmaliger Vorgang während der Erst-Assemblierung des Piezo-Biegewandlers durchgeführt werden, um diesen erstmalig in eine Referenz-Ausrichtung beziehungsweise die Referenzposition zu bringen. In diesem Fall kann die für die Schmelzung der Zwischenschicht erforderliche Schmelzwärme beispielsweise durch Heißluft oder durch eine Lötspitze zugeführt werden.

Weiterhin können über die Lebensdauer des Druckkopfes oder Beschichtungskopfes Ausrichtprozesse mehrmals oder in regelmäßigen Abständen durchgeführt werden, beispielsweise im jährlichen, monatlichen, wöchentlichen, täglichen oder stündlichen Turnus. Durch regelmäßiges Durchführen von Ausrichtprozessen kann ein Piezo-Biegewandler und somit alle Piezo-Biegewandler eines Piezo-Biegewandler-Arrays über viele Jahre hinweg stets präzise in seiner Referenz-Ausrich-

Neben der so erhaltenen Langzeitstabilität weisen vielkanalige Druck- oder Beschichtungsköpfe, die auf den Piezoaktuatoren basieren und einen oder mehrere von diesen umfassen, bereits ab der Fertigstellung und nach erfolgtem erstmaligen Ausrichtprozess nur minimale Unterschiede zwischen den einzelnen Kanälen auf.

In diesem Kontext wird weiterhin vorgeschlagen, im Rahmen einer Qualitätssicherung während eines Druck- oder Beschichtungsbetriebes oder mittels Probeausdrucken oder Testbeschichtungen fortlaufend Abweichungen im Druckbild zu erfassen, die auf Unterschiede zwischen den Kanälen des Druck- oder Beschichtungskopfes hinweisen können und einen oder mehrere zeitnahe Ausrichtprozess(e) durchzuführen. So können beispielsweise gezielt Anpassungen von Druck- oder Beschichtungsprozessen durch Vergrößerungen oder Verkleinerungen der Stellbereiche oder durch Verschieben der Stellbereiche der Piezoaktuatoren vorgenommen werden. In diesem Zusammenhang bietet es sich insbesondere an, den Ausrichtprozess unter geänderten elektrischen Ladungszuständen, also durch Anlegen veränderter elektrischer Spannungen an die Elektroden des Piezo-Biegewandlers, durchzuführen, im Vergleich zum zuletzt durchgeführten Ausrichtprozess.

Somit wird vorgeschlagen, dass ein entsprechender Ablauf für eine Anpassung eines Druckkopfes oder Beschichtungskopfes an eine Applikation oder für die Durchführung einer Qualitäts-verbessernden Maßnahme die folgenden Schritte zumindest einmalig enthält:

a) das Durchführen eines Tropfen- oder Strahlausstoßes aus den Düsen und/oder das Anfertigen eines Testausdruckes oder das Durchführen einer Testbeschichtung mittels des Druckkopfes oder Beschichtungskopfes;

b) die messtechnische, optische oder visuelle Erfassung und Qualifizierung des Testausdruckes beziehungsweise der Testbeschichtung, beispielsweise durch Messung der Schichtdicken, der Randschärfen, des Glanzgrades, der Schicht-Ebenheit und die Erkennung von Spritzern oder Satellitentropfen oder durch optische Inspektion der dynamischen Tropfenabgabe einschließlich der Strahl- oder Tropfengeschwindigkeiten, Verfallsprozesse und der Erkennung von Ablagerungen von Beschichtungsmittel an den Druckköpfen, insbesondere an den Düsenauslässen;

c) das Durchführen eines Ausrichtprozesses, wobei sich die an den Elektroden des Piezo-Biegewandlers angelegten elektrischen Spannungen unterscheiden von denen des letzten Ausrichtprozess oder unter die Position des Referenzanschlages verändert ist im Vergleich zu der des letzten Ausrichtprozesses.

Dabei sei darauf hingewiesen, dass dies insgesamt als ein iterativer Prozess angesehen werden kann, wobei es bevorzugt ist, schon vor dem ersten Schritt nach a) einen Ausrichtprozess nach c) durchzuführen und dien iterativen Prozess letztendlich nach einem Schritt b) zu beenden, wenn dieser zu zufriedenstellenden Ergebnissen geführt hat.

Sind wiederholt Ausrichtprozesse vorgesehen, so werden bevorzugt bereits ein oder mehrere Heizelemente in die vorgenannten Druckköpfe oder Beschichtungsköpfe fest integriert, die vorzugsweise mit dem Gehäuse verbunden sind und in thermischem Kontakt mit der dem Gehäuse zugeordneten Fläche des zweiten Lagerbereiches stehen. In diesem Fall können die Heizelemente sowie die an die Elektroden der Piezo-Biegewandler anzulegenden elektrischen Spannungen über eine Prozesssteuerung gesteuert werden. Dies kann optional dieselbe Prozesssteuerung sein, welche die gesamte Steuerung der Druck- oder Beschichtungsprozesse vornimmt, oder sie kann dieser untergeordnet sein. Hierzu sei lediglich angemerkt, dass eine solche Steuerung mittels einfacher Vorgabe einer Heizleistung und Zeitdauer oder (bevorzugt) mittels einer Temperaturregelung, bevorzugt basierend auf der Messung der tatsächlichen Temperatur nahe am zweiten Lagerbereich mittels eines Temperatursensors, erfolgen kann.

Bevorzugt wird durch die Prozess-Steuerung die durch das Heizelement abgegebene Heizleistung so kontrolliert, dass die Temperatur im zweiten Lagerbereich über die Schmelztemperatur der Zwischenschicht angehoben wird und die Zwischenschicht für eine Zeitdauer in der Größenordnung von 1 Sekunde, 10 Sekunden oder 100 Sekunden geschmolzen wird.

Es sei hier erwähnt, dass ein erstmaliger Ausrichtprozess bei der Erst-Assemblierung eines Druckkopfes oder Beschichtungskopfes oder eines Bauteils, das ein oder mehrere erfindungsgemäße Piezoaktuatoren enthält, durchgeführt wird. Auch dann kann das Verflüssigen der Zwischenschicht im Ausrichtmodus mit einem integrierten Heizelement, das in thermischen Kontakt mit dem zweiten Lagerbereich steht, vorgenommen werden. Alternativ kann jedoch das Verflüssigen der Zwischenschicht auch durch eine äußere Wärmequelle wie beispielsweise durch Heißluft oder mittels eines Lötkolbens erfolgen, der mit dem Material der Zwischenschicht oder mit einer der an diese angrenzenden Flächen in Kontrakt gebracht wird.

Bevorzugt kann die Zwischenschicht beispielsweise aus einem Lot mit einer Schmelztemperatur unter 150°C [Grad Celsius], 200°C oder 250°C bestehen. Dieses kann gleichzeitig verwendet werden, um entweder die Trägerschicht des Piezo-Biegewandlers oder eine Elektrode einer Piezolamelle elektrisch zu kontaktieren. Eine weitere Möglichkeit ist dass die Zwischenschicht aus einem Schmelzkleber, thermoplastischen Kunststoff, einem thermoplastischen Elastomer (TPE), einem Bitumen oder einem Wachs besteht, deren Schmelztemperatur unter 100°C, 150°C, 200°C oder 250°C liegt.

Hierzu sei angemerkt, dass die durch die Erwärmung hervorgerufene maximale Temperatur der Piezolamellen der Piezo-Biegewandler ausreichend weit unter der Curie-Temperatur des Piezomaterials bleiben sollte. Daher sind grundsätzlich alle Materialien mit ausreichend niedrigem Schmelzpunkt für die Verwendung als Zwischenschicht bevorzugt, die es damit erlauben, das Material der Zwischenschicht aufzuschmelzen, ohne dass die dadurch hervorgerufene maximale Temperatur der Piezolamelle sich der Curie-Temperatur des Piezomaterials annähert.Die Verwendung eines Lotes oder thermoplastischen Kunststoffes als Zwischenschicht führt überwiegend zu einer festen Verbindung und schließt eine Verdrehungstoleranz direkt an der Verbindungsstelle aus. In diesem Fall müssen erforderliche Elastizitäten innerhalb der einzelnen Lagerbereiche separat hinzugefügt werden. Im Falle eines thermoplastischen Elastomers w(TPU, TPE) kann bereits aufgrund der Elastizität des Materials eine Drehtoleranz des entsprechenden zweiten Lagerbereiches erreicht werden.

Die Ausrichtung des Piezo-Biegewandlers gegen den Referenzanschlag erfolgt unter der Wirkung eines Bias-Drehmomentes während der Dauer einer Ausrichtzeit $T_A$. Der erfindungsgemäße Piezoaktuator verfügt daher über Mittel zur Beaufschlagung eines Bias-Drehmomentes auf den Piezo-Biegewandler um den ersten Lagerbereich, wobei das Bias-Drehmoment so aufgebracht wird, dass das bewegliche Ende des Piezo-Biegewandlers oder ein damit verbundener Effektor gegen einen Referenzanschlag gedrückt wird.

Das Bias-Drehmoment wird aufgebracht, indem mittels eines Andruckelementes eine definierte Kraft F auf den Piezo-Biegewandler ausgeübt wird, wobei die Kontaktstelle des Andruckelementes mit dem Piezo-Biegewandler längs des Piezo-Biegewandlers um einen seitlichen Versatz x vom Drehpunkt des ersten Lagerbereiches versetzt liegt. Für die Höhe der Kraft F und den Versatz x in Abhängigkeit der Klemmkraft FK des Piezo-Biegewandlers und des Abstandes $L_R$ des ersten Lagerbereiches zu der Aktuationsstelle des Piezo-Biegewandlersgilt dabei der Zusammenhang: $F * x < 0,5 * FK * L_R$. Die konstruktive Umsetzung dieser Kraftaufbringung wird anhand der Ausführungsbeispiele gemäß den Figuren besprochen.

Es sei erwähnt, dass ein entsprechender Piezo-Biegewandler 2 eines erfindungsgemäßen Piezoaktuators monomorph aufgebaut sein kann mit nur einer einzigen Piezolamelle 3, die mit einer Trägerschicht 4 verklebt ist, oder bimorph aufgebaut sein kann mit zwei Piezolamellen 3, die beidseitig mit der Trägerschicht 4 verklebt sind, wobei die ein oder zwei Piezolamellen 3 die Trägerschicht (4) beispielsweise überwiegend im Bereich einer freien Länge L1 des Piezo-Biegewandlers bedecken oder die ein oder zwei Piezolamellen 3 die Trägerschicht 4 im Wesentlichen vollständig bedecken.

Neben den zuvor beschriebenen Maßnahmen zur Sicherung, Anpassung oder Wiederherstellung konstanter Betriebsbedingungen von Piezoaktuatoren, wird weiterhin durch eine zweite Lagerungsart LA2 des Piezo-Biegewandlers in dem erfindungsgemäßen Piezoaktuator eine im Vergleich zum Stand der Technik weit verbesserte Leistungsfähigkeit des Piezo-Biegewandlers erreicht. Dies eröffnet den Zugang zu Applikationen mit höheren Leistungsanforderungen und/oder höherer Leistungsdichte. Umgekehrt kann bei einer unveränderten Applikation mit unveränderter Aktuations- Stellarbeit eine Reduktion der Ansteuerspannungen und damit eine deutliche Reduktion der elektrischen Spannungsbelastung und mechanischen Spannungsbelastung der Piezoelemente vorgenommen werden, was deren Langzeitfestigkeit deutlich bis in einen Bereich der Dauerfestigkeit verbessern kann. Oder es kann eine Verringerung der Breite der Piezo-Biegewandler und damit im Falle eines Druckkopfes oder Beschichtungskopfes eine Verringerung der Kanalbreite beziehungsweise des Abstandes der Abgabedüsen untereinander, beziehungsweise eine Verbesserung der Druckauflösung vorgenommen werden bei im Vergleich zum Stand der Technik unveränderter Aktuationsleistung je Einzelaktuator beziehungsweise pro Druckkanal.

In einer bevorzugten Ausführungsform ist ein Piezoaktuator dabei gekennzeichnet durch eine Aktuationsstelle an dessen beweglichen Ende oder durch einem damit verbundenen Effektor zur Durchführung einer Stellbewegung, weiterhin durch einen mittig gelegenen eng begrenzten Lagerbereich, welcher Bereiche des Aktuators und des Gehäuses umfasst, und weiterhin durch einen seitlich gelegenen eng begrenzten Lagerbereich am entgegengesetzten Ende des beweglichen Endes, welcher ebenso Bereiche des Aktuators und des Gehäuses umfasst, wobei der mittig gelegenen Lagerbereich und der seitlich gelegene Lagerbereich Elastizitäten enthalten, welche jeweils Drehungen des Piezo-Biegewandlers lokal von zumindest +/- 2° [Grad]erlauben. Dabei befindet sich der mittig gelegene Lagerbereich bevorzugt innerhalb des mittleren Drittels des Piezo-Biegewandlers.

Hierzu sei zur Verdeutlichung der Nomenklatur angemerkt, dass die zuvor beschriebenen Lagerbereiche, der "erste Lagerbereich" und der "zweite Lagerbereich" jeweils sowohl dem hier genannten "mittig gelegenen Lagerbereich" oder dem "seitlich gelegenen Lagerbereich" entsprechen können. Somit richten sich die Nomenklaturen "erster Lagerbereich" und "zweiter Lagerbereich" nach deren Funktion und Ausführung, während sich die Nomenklaturen "mittig gelegener Lagerbereich" und "seitlich gelegener Lagerbereich" nach deren Lage richten.

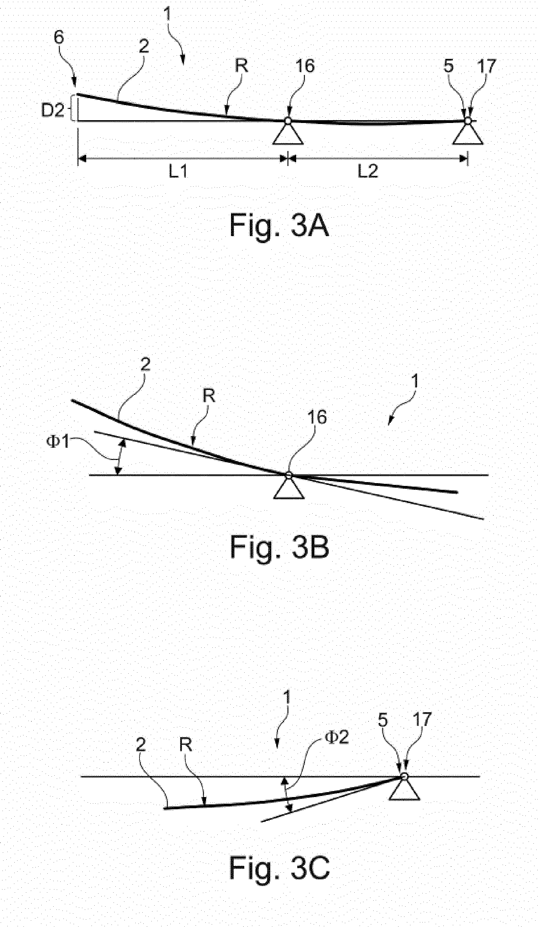

In der zweiten Lagerungsart LA2 ist der mittig gelegene Lagerbereich vorzugsweise im mittleren Drittel des Piezo-Biegewandlers angeordnet und der und der seitlich gelegene Lagerbereich am dem beweglichen Ende des Piezo-Biegewandlers entgegengesetzten Ende des Piezo-Biegewandlers angeordnet. Beide sind eng begrenzt beziehungsweise punktuell ausgeführt und so beschaffen, dass sie die Drehbewegungen des Piezo-Biegewandlers um diese Lager ohne nennenswerten Widerstand zulassen beziehungsweise tolerieren, welche aus den Verformungen des Piezo-Biegewandlers resultieren. Aufgrund dieser Lagerungs-Konstellation ergibt sich eine nutzbare erste Eigenform des Piezo-Biegewandlers, welche beispielsweise in Fig. 3A gezeigt ist. Im Vergleich zu der üblicherweise festen Einspannung eines Piezo-Biegewandlers, wie in Fig. 1 skizziert, ist diese dadurch gekennzeichnet, dass bei gegebenem Biegeradius R des Piezo-Biegewandlers (gleiche Ansteuerspannung und Verformung) und einer gegebenen freier Länge L1 eine erheblich größerer Stellweg (D2 in Fig. 3A statt D1 in Fig. 1) im Vergleich zum fest eingespannten Piezo-Biegewandler erreicht wird, ohne dass sich dessen Steifheit und somit Aktuationskraft verringert. Der wesentlich höhere beziehungsweise größere Stellweg liegt in der Tatsache begründet, dass an dem mittig angeordneten Lagerbereich die Verformungskurve des Piezo-Biegewandlers bereits eine Verdrehung Φ aufweist, welche die Endauslenkung D2 vergrößert, siehe beispielsweise Fig. 3A. Es sei dabei erwähnt, dass der Piezo-Biegewandler im Bereich der Länge L2, also zwischen dem mittig gelegenen und seitlich gelegenen Lagerbereich, in die entgegengesetzte Richtung auslenkt wie im Bereich der freien Länge L1, welche das bewegliche Ende des Piezo-Biegewandlers einschließt.

Weiterhin weist ein so gelagerter Piezo-Biegewandler einen über seine Länge gleichmäßigeren Momenten-Verlauf auf als die übliche feste Einspannung wie dargestellt in Fig. 1, wo es zu einem starken Belastungs-Maximum an der Einspannung kommt. Dieses ist eine häufige Ursache für belastungsbedingte Ausfälle.

Damit die in Fig. 3A gezeigten Eigenformen des Piezo-Biegewandlers möglich sind, müssen der mittig gelegene Lagerbereich (Fig. 3B) und der seitlich gelegene Lagerbereich (Fig. 3C) entsprechend der Verformungskurve des Piezo-Biegewandlers Drehungen des Piezo-Biegewandlers ermöglichen, aber zumindest in der Richtung parallel zur Stellbewegung den Piezo-Biegewandler fest unterstützen. Hierzu werden hierfür unterschiedliche technische Umsetzungsmöglichkeiten vorgeschlagen. So besteht die Möglichkeit der Verwendung von relativ zum Gehäuse festen Auflagern, beispielsweise ausgeführt als aus einem Gehäuse-Anbauteil vorstehende feste, spitzen- oder linienförmig ausgeführte Kontaktelemente, auf die der Piezo-Biegewandler aufsitzt und Kippbewegungen aus der Ebene der Piezolamellen hinaus ausführen kann. Dabei muss der Piezo-Biegewandler mit ausreichender Andruck-Kraft auf das Auflager gedrückt werden, um ein Abheben des Piezo-Biegewandlers insbesondere bei höheren Stellkräften und/oder hochdynamischer Betriebsweise zu verhindern. Diese Andruck-Kraft wird im entsprechenden Lagerbereich auf der dem Auflager gegenüberliegenden Seite des Piezo-Biegewandlers aufgegeben mithilfe von beweglichen Feder-betätigten Kontaktelementen wie beispielsweise metallischen Spiral-, Biegefedern, elektrischen Kontaktfedern, oder elastomeren Elementen.

Neben der Verwendung von Auflagern in Kombination mit Andruckelementen lässt sich eine punktuelle, drehbare Unterstützung des Piezo-Biegewandlers auch dadurch erreichen, dass der jeweilige Lagerbereich zum einen eine im Wesentlichen translatorische Fixierung bietet. Zusätzlich, um die entsprechend der Biegelinie des Piezo-Biegewandlers erforderlichen Drehbewegungen in dem mittig und seitlich angeordneten Lagerbereich zu erhalten, wird weiterhin vorgeschlagen, dass diese Lagerbereiche Elastizitäten beinhalten, die Drehbewegungen um einen jeweiligen - gegebenenfalls virtuellen - Drehpunkt des jeweiligen Lagerbereiches ermöglichen.

Diese können beispielsweise Elastizitäten des Piezo-Biegewandlers innerhalb eines jeweiligen Lagerbereiches sein, wie diskrete elastische Elemente oder Strukturelastische Bereiche der Trägerschicht, die mit dem jeweiligen Lagerbereich assoziiert und die lokal nicht durch Piezolamellen belegt sind. Dies kann beispielsweise ein Bereich der Trägerschicht sein, der seitlich (im Falle des seitlich gelegenen Lagerbereichs) aus den ein oder zwei Piezolamellen hervorragt. Vorgenannte Elastizitäten können weiterhin elastische Zwischenschichten aus elastomeren Materialien in den jeweiligen Lagerbereichen sein. Weiterhin kann es sich um Elastizitäten handeln, die mit dem Gehäuse oder damit verbundenen weiteren elastischen oder Feder-artigen Bauteilen zwischen dem Gehäuse und dem jeweiligen Lagerbereich assoziiert sind. Diese Elastizitäten sind so konfiguriert, dass sie eine Drehung des Piezo-Biegewandlers lokal im Bereich des jeweiligen Lagerbereiches zumindest in geringem Umfang erlauben. Spezifische Ausführungsbeispiele hierzu werden anhand der Figuren erläutert.

Zu den Größenverhältnissen sei angemerkt, dass die Länge L1 des Piezo-Biegewandlers beispielsweise je nach Anwendungsfall zwischen 4 mm und 6 mm, zwischen 5 mm und 9 mm oder zwischen 7 mm und 15 mm beträgt. Das Verhältnis der Längen L1/L2 beträgt bevorzugt zwischen 0,5 und 2. Die mindestens eine Piezolamelle kann die Trägerschicht überwiegend im Bereich der freien Länge L1 oder in den Bereichen L1 und L2, also beiderseits des jeweils mittigen Lagerbereiches bedecken. Letzterer Fall ist nur für die Lagerungsvariante LA2 sinnvoll und führt zu den höchsten Auslenkungen.

Ein entsprechendes Piezoaktuator-Array besteht bevorzugt aus identischen, erfindungsgemäßen Piezoaktuatoren mit entsprechenden Piezo-Biegewandlern. Diese weisen je nach der Art der Applikation bevorzugt untereinander einen konstanten Abstand auf zwischen 0,5 mm und 1 mm, zwischen 0,75 mm und 2 mm oder zwischen 1,5 mm und 5 mm. Die Breite (B) des Zwischenraumes benachbarter Piezo-Biegewandler beträgt bevorzugt zwischen 0,05 mm und 0,2 mm, zwischen 0,1 mm bis 0,3 mm oder zwischen 0,2 mm bis 0,6 mm. Weiterhin liegen jeweils die ersten und zweiten Lagerbereiche respektive die mittig und seitlich gelegenen Lagerbereiche der jeweiligen Piezo-Biegewandler auf jeweils einer Linie.

Ferner liegen in einem Piezoaktuator-Array die Kontaktstellen der Andruckelemente, die Drehpunkte der jeweiligen Lagerbereiche und die Aktuationsstellen der einzelnen Piezo-Biegewandler jeweils auf einer Linie.

Ferner besteht ein Piezoaktuator-Array bevorzugt aus einem Teil, das zumindest alle Piezo-Biegewandler und Lagerbereiche einschließlich der mit dem Gehäuse assoziierten Teile der Lagerberieche enthält. Vorteilhaft ist hierfür die Verwendung von dreh-elastischen Verbindungen zwischen benachbarten Piezo-Biegewandlern des Arrays beispielsweise an den jeweiligen ersten Lagerbereichen.

Weiterhin bestehen auch die oben beschriebenen und mit dem Gehäuse assoziierten Komponenten der jeweiligen ersten Lagerbereiche wie Auflager und Andruckfedern und der jeweiligen zweiten Lagerbereiche bevorzugt aus einer strukturierten Platte.

Definition: Mit der Bezeichnung "Lagerbereich" werden alle Komponenten im Zusammenhang mit einem Lager oder einer Lagerung verstanden zwischen einem Punkt, einem schmalen oder einem breiteren Bereich des Piezo-Biegewandlers und einem dem Lager oder der Lagerung zuzurechnenden Teil des Gehäuses 31 oder damit verbundener Komponenten, welche einen wirksamen Beitrag zum Verhalten des Lagers oder der Lagerung, sei es als feste Lagerung oder als Drehlagerung, liefern. Dadurch soll der Tatsache Rechnung getragen werden, dass eine Drehlagerung mitunter durch hierfür wirksame Elastizitäten im Bereich des Lagers oder der Lagerung erreicht wird.

Vorsorglich sei angemerkt, dass die hier verwendeten Zahlwörter ("erste", "zweite",...) vorrangig (nur) zur Unterscheidung von mehreren gleichartigen Gegenständen, Größen oder Prozessen dienen, also insbesondere keine Abhängigkeit und/oder Reihenfolge dieser Gegenstände, Größen oder Prozesse zueinander zwingend vorgeben. Sollte eine Abhängigkeit und/oder Reihenfolge erforderlich sein, ist dies hier explizit angegeben oder es ergibt sich offensichtlich für den Fachmann beim Studium der konkret beschriebenen Ausgestaltung.

Die Erfindung sowie das technische Umfeld werden nachfolgend anhand der Figuren näher erläutert. Es ist darauf hinzuweisen, dass die Erfindung durch die gezeigten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung und/oder Figuren zu kombinieren. Insbesondere ist darauf hinzuweisen, dass die Figuren und insbesondere die dargestellten Größenverhältnisse nur schematisch sind. Gleiche Bezugszeichen bezeichnen gleiche Gegenstände, so dass ggf. Erläuterungen aus anderen Figuren ergänzend herangezogen werden können. Es zeigen:

Fig. 1 zeigt das Prinzip-Bild eines Piezoaktuators 1 nach einer ersten Lagerungsart LA1.

Fig. 2A zeigt das Prinzip-Bild eines Piezoaktuators 1 nach einer zweiten Lagerungsart LA2, wobei der erste Lagerbereich 7 mittig des Piezo-Biegewandlers 2 gelegen ist und der zweite Lagerbereich 8 seitlich am unbeweglichen Ende 6 gelegen und schmal ausgeführt ist.

Fig. 2B zeigt das Prinzip-Bild eines Piezoaktuators 1 nach der zweiten Lagerungsart LA2, wobei der zweite Lagerbereich 8 mittig gelegen ist und der erste Lagerbereich 7 seitlich am unbeweglichen Ende 6 des Piezo-Biegewandlers 2 gelegen ist.

Fig. 3A zeigt das Prinzip-Bild eines Piezoaktuators 1 nach der zweiten Lagerungsart LA2 mit vergrößerter Darstellung der besonderen Eigenform des ausgelenkten Piezo-Biegewandlers 2. Fig. 3B und 3C zeigen eine weitere Vergrößerung des mittig gelegenen 16 und seitlich gelegenen 17 Lagerbereiches.

Fig. 4A zeigt die Aufsicht eines Ausführungsbeispiels für ein Piezoaktuator-Array aus Piezoaktuatoren 1, Fig. 4B einen seitlichen Schnitt.

Fig. 5 zeigt einen seitlichen Schnitt eines weitere Ausführungsbeispiels für ein Piezoaktuator-Array aus Piezoaktuatoren 1.

Fig. 6A und 6B zeigen weitere Ausführungsformen für zweite Lagerbereiche 8.

Fig. 1 zeigt das Prinzip-Bild eines Piezoaktuators 1, bestehend aus einem Piezo-Biegewandler 2 in um D1 am beweglichen Ende 6 ausgelenktem Zustand, wobei in diesem Fall das bewegliche Ende 6 auch die Aktuationsstelle 14 repräsentiert, welche ein beliebiges Stellglied, vorzugsweise das Schließelement eines Mikroventils kontaktiert. Weiterhin gezeigt ist ein erster, in gewissen Grenzen von +/- 5 ° [Grad] drehbarer Lagerbereich 7, der als Auflager 9 konfiguriert ist, welches den Drehpunkt 22 des ersten Lagerbereiches 7 repräsentiert und der weiterhin mit dem Gehäuse 31 verbunden ist. Der Abstand zwischen dem Drehpunkt 22 des ersten Lagerbereiches 7 und der Aktuationsstelle beträgt $L_R$. Weiterhin gezeigt ist ein zweiter, hier lateral entlang des Piezo-Biegewandlers ausgedehnter Lagerbereich 8 mit einer Zwischenschicht 12 aus einem verflüssigbaren beziehungsweise schmelzbaren Material zwischen einer Piezo-Biegewandler-seitigen Fläche 10 und einer Gehäuse-seitigen Fläche 11 des zweiten Lagerbereiches 8.

Durch seine breite Ausdehnung verhält sich der zweite Lagerbereich 8 dieses Ausführungsbeispiels insgesamt wie eine feste Einspannung und repräsentiert mit dieser Eigenschaft hier eine erste Lagerungsart (LA1). Dennoch wirkt, wie gezeigt, permanent ein Bias-Drehmoment 34 auf den Piezo-Biegewandler 2 um den ersten Lagerbereich 7, hervorgerufen durch eine nach unten gerichtete Kraft F, die an der Kontaktstelle 23 angreift, welche sich um einem Abstand x entlang des Biegewandlers versetzt vom Drehpunkt 22 des ersten Lagerbereiches 7 befindet. Das Bias-Drehmoment 34 wird so bemessen, dass es eine geringfügige konstante Momenten-Belastung des Piezo-Biegewandlers 2 darstellt, die ausreicht, um diesen im Falle einer geschmolzenen, also kraftfreien, Zwischenschicht 12 gegen einen Referenzanschlag 15 zu drehen, der eine Referenzposition 40 einer Stellbewegung 13 des Piezo-Biegewandlers 2 definiert. Wie oben dargelegt, lässt sich die Zwischenschicht 12 in einem Ausrichtmodus verflüssigen durch Schmelzen der Zwischenschicht 12. Beispielsweise während der Montage durch Wärmezufuhr durch eine äußere Wärmequelle 38 in Form einer Heißluft-Zufuhr oder durch Verwendung eines Lötkolbens. Wie oben beschrieben, kann der Ausrichtprozess auch während des Betriebes in kurzen Unterbrechungen wiederholt durchgeführt werden, durch Verwendung eines integrierten Heizelementes 28 im Zusammenspiel mit einem Steuergerät unter optionaler Temperaturkontrolle mittels eines Temperatursensors 37. Dabei sind Heizelement 28 und Temperatursensor 37 beispielsweise mit dem Gehäuse 31 verbunden und stehen in engem thermischem Kontakt zu dem zweiten Lagerbereich 8. Nicht dargestellt sind hier mögliche Isolierschichten 39 unterhalb des Heizelementes, welche verhindern, dass ein zu großer Teil der Wärme in das Gehäuse 31 fließt.

Fig. 2A zeigt das Prinzip-Bild eines Piezoaktuators 1 gemäß einer zweiten Lagerungsart (LA2). Zur Vermeidung von Wiederholungen wird auf die Beschreibung zu Fig. 1 Bezug genommen, im Folgenden sollen nur die Unterschiede aufgezeigt werden. Die zweite Lagerungsart unterscheidet sich von der ersten Lagerungsart (LA1) wie in Fig. 1 dadurch, dass der zweite Lagerbereich 8 räumlich eng begrenzt ist und so beschaffen ist, dass er Drehbewegungen in geringem Umfang von beispielsweise bis zu +/-2 ° [Grad] ausführen kann. Die Ersetzung der festen Lagerung wie in Fig. 1 des zweiten Lagerbereiches 8 durch eine Drehlagerung führt zu einer abweichenden Biegeline des Piezo-Biegewandlers 2 im Gegensatz zu Fig. 1, welche die Realisierung eines Piezoaktuators 1 mit weit höherer Aktuationsleistung ermöglicht. In Fig. 1 und Fig. 2A entspricht der erste Lagerbereich 7 dem mittig gelegenen Lagerbereich 16 (vgl. Fig. 3A, 3B) der zweiten Lagerungsart und der zweite Lagerbereich 8, die Zwischenschicht 12 enthält, dem seitlich gelegenen Lagerbereich 17 der zweiten Lagerungsart LA2 (vgl. Fig. 3A, 3C).

In Fig. 2B gezeigt ist eine zweite Möglichkeit der Umsetzung der zweiten Lagerungsart LA2, welche sich von der in Fig. 2A gezeigten Möglichkeit dadurch unterschiedet, dass nun der erste Lagerbereich 7 dem seitlich gelegenen Lagerbereich 17 der zweiten Lagerungsart und der zweite Lagerbereich 8, die Zwischenschicht 12 enthält, dem mittig gelegenen Lagerbereich 16 der zweiten Lagerungsart LA2 entspricht. Auch hier wird auf die Beschreibung zu Fig. 1 und Fig. 2A verwiesen, um Wiederholungen zu vermeiden. Es werden nur die Unterschiede aufgezeigt.

Es sei erwähnt, dass die Reihenfolge der Lagerbeiche wie in Fig. 2B auch auf die erste Lagerungsart LA1 übertragbar ist. Jedoch auch hier liegt zwischen den Lagerungsarten darin, dass in der Lagerungsart LA1 der zweite Lagerbereich 8 breit und als festes Lager ausgeführt ist.

Fig. 3A zeigt die Biegeline eines Piezo-Biegewandlers 2 nach der zweiten Lagerungsart LA2. Diese stellt die erste Eigenform des Piezo-Biegewandlers 2 unter der Randbedingung eines mittig gelegenen Lagers 16 und eines seitlich gelegenen Lagers 17 dar, die beide gegenüber den lokalen Drehverformungen des Piezo-Biegewandlers 2 tolerant sind. Dabei ist bevorzugt die gesamte Länge L1 + L2 des Piezo-Biegewandlers 2 mit Piezolamellen einseitig (monomorph) oder zweiseitig belegt. Hierbei bezeichnet L1 eine freie Länge L1 des Piezo-Biegewandlers 2, die die frei bewegliche Länge des Piezo-Biegewandlers 2 zwischen dem mittleren Lager 16 und dem beweglichen Ende 6 angibt. Ein unbewegliches Ende 5 des Piezo-Biegewandlers 2 ist an dem seitlich gelegenen Lager 17 festgelegt. Um den Unterschied des Stellweges am beweglichen Ende 6 mit einem Piezo-Biegewandler 2 der ersten Lagerungsart LA1 wie in Fig. 1 zu vergleichen, wird davon ausgegangen, dass der Piezo-Biegewandler 2 nach Fig. 1 in seinem freien Bereich L1 identisch aufgebaut ist wie der Piezoaktuator 1 aus Fig. 3A. Somit weisen beide im ausgelenkten Zustand einen Krümmungsradius von R auf. Es ist erkennbar, dass bei gleichem Krümmungsradius die resultierende Auslenkung D2 im Falle der zweiten Lagerungsart LA2 erheblich höher ist als im Falle der ersten Lagerungsart LA1.

Fig. 3B und Fig. 3C zeigen respektive eine weiter vergrößerte Darstellung der Verformung des Piezo-Biegewandlers 2 gemäß Fig. 3A am mittleren Lagerbereich 16 (Fig. 3B) und seitlichen Lagerbereich 17 (Fig. 3C) zur Verdeutlichung der Verdrehungen φ1 und φ2. Diese bewegen sich im Betrieb üblicherweise in einem Bereich von +/- 2 Grad.

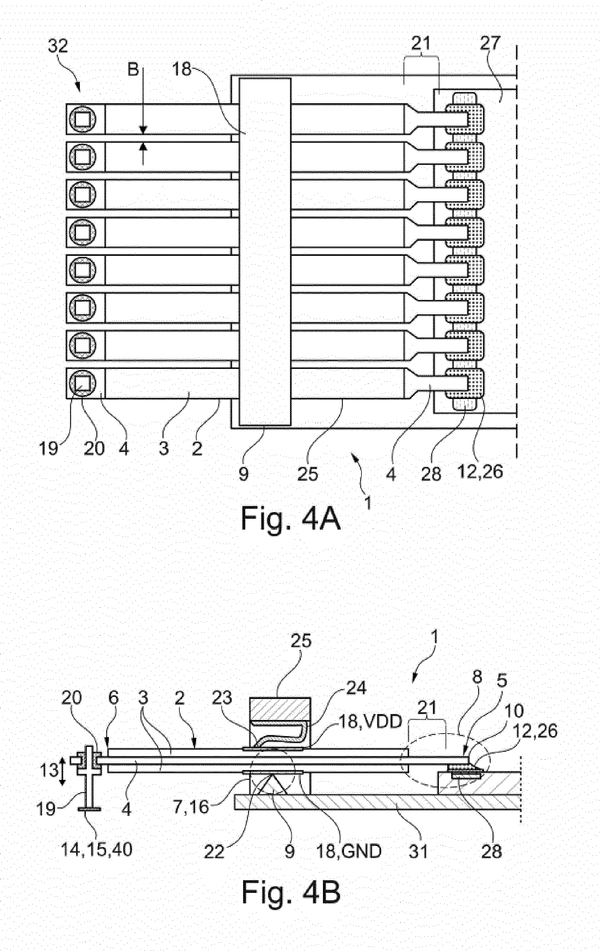

Die Figuren 4A und 4B zeigen exemplarisch ein Ausführungsbeispiel für ein Piezoaktuator-Array 32 mit bimorphen Piezoaktuatoren 2, gelagert gemäß der zweite Lagerungsart LA2 und in der Konfiguration nach den Figuren 2A und 3A. In diesem Fall entspricht dem mittig gelegenen Lagerbereich 16 der erste Lagerbereich 7, gestrichelt in Fig. 4B dargestellt, mit einem Auflager 9 als Drehlager, und der seitlich gelegene Lagerbereich 17 dem zweiten Lagerbereich 8 zur Durchführung einer Stellbewegung 13 am beweglichen Ende 6 des Piezo-Biegewandlers 2. Links dargestellt am beweglichen Ende 6 befinden sich Effektoren 19, die an ihrer Spitze die Aktuationsstelle 14 aufweisen. Die Effektoren 19 sind vorzugsweise über eine elastische Verbindung 20, welche in diesem Fall beispielsweise ein elastomeres Zwischenstück oder eine elastische Verklebung sein kann, mit dem Piezo-Biegewandler 2 verbunden. Die elastische Verbindung 20 vermindert die Übertragung von Stößen von der Aktuationsstelle 14 auf den Piezo-Biegewandler 2 und bietet gleichzeitig eine gewisse Drehtoleranz für den Effektor 19.

Die Aufgabe des Bias-Drehmomentes 34 erfolgt im Ausführungsbeispiel mittels eines Andruckelementes 24 in Form zungenartig strukturierter und optional gebogener Anpressfeder-Bänder oder -Arrays 24, welches sich unterhalb einer Haltebrücke 25 befindet. Die Federn können eine beliebige sinnvolle Form haben, sind jedoch so geformt, dass sie jeweils exakt an den Kontaktstellen 23 eine Kraft F auf die einzelnen Piezo-Biegewandler 2 ausüben. Hierfür können sie optional jeweils ein separates Andruck-Element aufweisen.

Die elektrische Kontaktierung der Piezo-Biegewandler 2 erfordert die Kontaktierung aller Piezolamellen 3 auf der Oberseite beispielsweise mit einer Betriebsspannung VDD von 100 V [Volt] bis 200V. und auf der Unterseite mit Masse (GND). Dies erfolgt auf der Oberseite und Unterseite jeweils mit ein oder mehreren zusammenhängenden Verbindungselektroden 18, welche quer zu den Piezo-Biegewandlern 2 verlaufen und beispielsweise als Kontaktbänder oder Kontaktdrähte aus Kupfer, Messing, Nickel oder aus dünnem, flexiblem Schaltungsträgermaterial durch Löten oder Verkleben unter Pressung während der Fertigung der Piezoaktuator-Arrays 32 aufgebracht werden.

Der zweite Lagerbereich 8, welcher die Zwischenschicht 12 enthält, befindet sich am unbeweglichen (rechten) Ende 5 des Piezo-Biegewandlers 2. Dargestellt ist eine Ausführungsform, in der eine Trägerschicht 4 aus einem lötbaren Material wie beispielsweise Nickel, Kuper oder Messing besteht. Somit umfasst der zweite Lagerbereich 8 einen Bereich der Trägerschicht 4, welcher nicht mit Piezolamellen 3 belegt ist und einen elastischen Bereich 21 des zweiten Lagerbereiches 8 darstellt. Dabei kann schon aufgrund einer geringen Stärke der Trägerschicht 4 von beispielsweise 30 µm bis 100 µm eine ausreichende Biege-Elastizität gegeben sein, um eine Biegelinie wie in Fig. 3A zu ermöglichen. In Fig. 4A wird gezeigt, dass die Trägerschicht 4 im elastischen Bereich 21 schmäler ausgeführt ist, was eine Reduktion der Biegekräfte im elastischen Bereich 21 herbeiführt.

Im Ausführungsbeispiel in Fig. 4A und 4B ist somit die Biegewandler-seitige Fläche 10 des zweiten Lagerbereiches 8 eine seitliche Fläche der Trägerschicht 4 des Piezo-Biegewandlers 2, welche nicht mit Piezolamellen 3 bedeckt ist. Die Zwischenschicht 12 besteht aus einem niedrig schmelzenden Lot und die Gehäuse-seitige Fläche 11 des zweiten Lagerbereiches 8 ist ein Kontakt-Pad 26 einer Leiterplatte 27. Letztere besteht vorzugsweise aus Keramik wie in Figs. 4A und 4B angenommen, oder einem Platinen-Material mit sehr hohem Tg. Bevorzugt befindet sich dann ein (Dickschicht-) Heizelement 28, getrennt nur durch eine elektrische Isolierschicht, direkt unterhalb aller Kontakt-Pads 26 der Piezo-Biegewandlers 2. In dieser Konfiguration besteht unmittelbarer thermischer Kontakt zu der Zwischenschicht 12, sodass diese innerhalb von Sekunden geschmolzen werden kann.

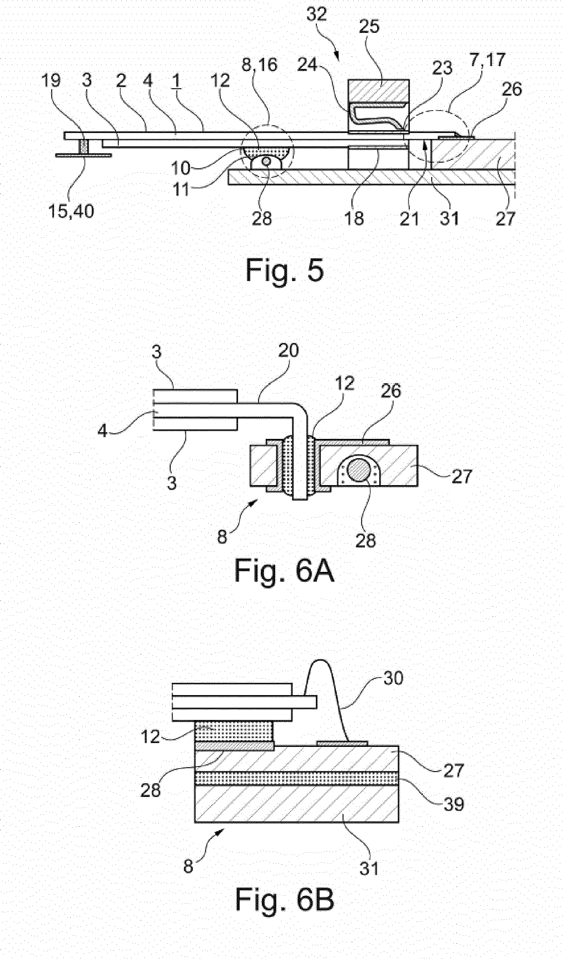

Fig. 5 zeigt exemplarisch einen seitlichen Schnitt eines Ausführungsbeispiels für ein Piezoaktuator-Array 32 mit monomorphen Piezoaktuatoren 1 mit Piezo-Biegewandlern 2 mit untenliegender Piezolamelle 3, gelagert gemäß der zweite Lagerungsart LA2 und in der Konfiguration gemäß der Figuren 2B und 3A. In diesem Fall entspricht dem mittig gelegenen Lagerbereich 16 der zweite Lagerbereich 8, gestrichelt dargestellt, und der seitlich gelegene Lagerbereich 17 dem ersten Lagerbereich 7, gestrichelt dargestellt. Letzterer ist realisiert durch die feste Verlötung der Trägerschicht 4 mit dem Kontakt einer Leiterplatte 27. Die Elastizität des hier ersten Lagerbereiches 7 wird wie in Fig. 4A und 4B durch die Trägerschicht im Bereich 21 dargestellt. Der zweite Lagerbereich 8 befindet sich in der Mitte des Piezo-Biegewandlers 2. Dieser wird gebildet durch eine elastische, schmelzbare Zwischenschicht 12, welche eine gute Adhäsion zu dem Piezo-Biegewandler 2 besitzt. Ein quer zu allen Piezo-Biegewandlern 2 verlaufender Heizdraht 28 innerhalb einer isolierenden Stützstruktur ist geeignet, die Zwischenschicht 12 unmittelbar von innen zu schmelzen. In dieser Konfiguration befindet sich das Andruckelement 24 in Form eines Anpressfeder-Arrays 24 zur Aufbringung der Bias-Momente 34 um die ersten Lagerbereiche 7 auf im Bild auf der rechten Seite.

In Fig. 6A wird eine Variante eines zweiten Lagerbereichs 8 gezeigt, in der der äußerste Teil der Trägerschicht 4 abgeknickt ist und durch eine Durchkontaktierung in einer Leiterplatte 27 ragt. Die Zwischenschicht 12 entspricht dem Lot in der Durchkontaktierung. Weiterhin befindet sich ein Heizer 28 in einer Nute unten in der Leiterplatte.

In Fig. 6B wird eine Variante eines zweiten Lagerbereichs 8 gezeigt mit einem schmelzbaren Elastomer oder einem elastischen Kleber als Zwischenschicht 12 auf der Leiterplatte 27. Beheizt wird durch eine Heizschicht 28 direkt unterhalb der Zwischenschicht 12 im direkten thermischen Kontakt. Gezeigt ist auch eine Isolierschicht 39 zwischen Leiterplatte 27 und Gehäuse 31.

Die Herstellung der Piezoaktuator-Arrays 32 erfolgt im Nutzen. So werden eine Vielzahl von beispielsweise 16, 32 oder 64 Piezolamellen 3 durch Sägeprozesse auf Sägefolien und/oder vorstrukturierte Biegewandler-Trägerschichten und/oder Mikro-Effektoren aus jeweils einer Platte des jeweiligen Materials im Nutzen gefertigt, also so, dass diese jeweils ein zusammenhängendes Teil bilden. Diese werden sodann im Nutzen zusammengefügt zu einem Monomorph- oder Bimorph-Piezo-Biegewandler-Array 32 und im Nutzen mit zusammenhängenden, elastischen Kontaktelektroden und im Nutzen mit den Mikro-Effektoren vergossen oder verklebt. Alternativ können die Piezolamellen 3 und vorstrukturierten Piezo-Biegewandler-Trägerstrukturen zuerst miteinander verklebt werden und erst im zweiten Schritt im Nutzen auf Sägefolie gesägt werden, um dann im Nutzen weiterverarbeitet zu werden.

Das Verfahren enthält den Schritt des Herstellens ein oder mehrerer Nutzen Piezoaktuator-Arrays 32 aus einer Vielzahl von erfindungsgemäßen Piezo-Biegewandlern 2, die seitlich nebeneinander angeordnet und eine zusammenhängende Struktur bilden, das Einsetzen dieser Struktur in einen Druckkopf oder Beschichtungskopf, sowie abschließend das Durchführen eines erfindungsgemäßen Ausrichtungsprozesses, in dem alle Piezoaktuatoren an ihren Referenzpositionen 40 ausgerichtet werden. Das Verfahren ist weiterhin dadurch gekennzeichnet, dass keine weiteren Abgleiche vorgenommen werden müssen.

Ein Piezoaktuator 1 zur Durchführung einer Stellbewegung 13 wird vorgeschlagen, mit einem Piezo-Biegewandler 2 aus einer Trägerschicht 4, die ein- oder zweiseitig mit einer Piezolamelle 3 zumindest teilweise belegt ist, mit einem beweglichen Ende 6 und mit einem Gehäuse 31, mit einem Referenzanschlag 15, der mit dem Gehäuse 31 verbunden ist, zur Festlegung einer Referenzposition 40 für die Stellbewegung 13, mit einem ersten Lagerbereich 7, der Bereiche des Piezoaktuators 1 und des Gehäuses 31 umfasst und welcher Verdrehungen Φ1 des Piezo-Biegewandlers 2 ermöglicht, mit einem zweiten Lagerbereich 8 mit einer Biegewandlerseitigen Fläche 10 und einer Gehäuse-seitigen Fläche 11 und einer Zwischenschicht 12 zwischen den Flächen, welche diese verbindet und welche verflüssigbar ist-und mit einem Andruckelement 24 zur Erzeugung eines Bias-Drehmomentes 34 auf den Piezo-Biegewandler 2 um den ersten Lagerbereich 7 gegen den Referenzanschlag 15.

### Bezugszeichenliste

| | |
|---|---|
| 1 | Piezoaktuator (Piezo-Biegewandler 2 + Gehäuse 31 + optionaler Effektor 19) |
| 2 | Piezo-Biegewandler |
| 3 | Piezolamellen |
| 4 | Trägerschicht |
| 5 | unbewegliches Ende des Piezo-Biegewandlers 2 |
| 6 | bewegliches Ende des Piezo-Biegewandlers 2 |
| 7 | erster Lagerbereich des Piezoaktuators 1, |
| 8 | zweiter Lagerbereich des Piezoaktuators 1 |
| 9 | Auflager im ersten Lagerbereich 7 |
| 10 | Biegewandler-seitige Fläche des zweiten Lagerbereiches 8 |
| 11 | Gehäuse-seitige Fläche des zweiten Lagerbereiches 8 |
| 12 | Zwischenschicht des zweiten Lagerbereiches 8 |
| 13 | Stellbewegung am beweglichen Ende 6 des Piezo-Biegewandlers 2 |
| 14 | Aktuationsstelle im Kontakt mit einem Stellelement |
| 15 | Referenzanschlag |
| 16 | Mittig gelegener Lagerbereich |
| 17 | Seitlich gelegener Lagerbereich |
| 18 | Verbindungselektrode |
| 19 | Effektor |
| 20 | Elastische Verbindung |
| 21 | Elastischer Bereich des zweiten Lagerbereiches |
| 22 | Drehpunkt des ersten Lagerbereichs |
| 23 | Kontaktstelle der Andruckkraft |
| 24 | Andruckelement, Anpressfeder-Array |
| 25 | Haltebrücke |
| 26 | Kontakt-Pad |
| 27 | Leiterplatte |
| 28 | Heizelement |
| 29 | Durchkontaktierung |
| 30 | Bonddraht |
| 31 | Gehäuse |
| 32 | Piezoaktuator Array |
| 33 | Prozesssteuerung |
| 34 | Bias-Drehmoment |
| 37 | Temperatursensor |
| 38 | Äußere Wärmequelle |
| 39 | Isolierschicht |
| 40 | Referenzposition |
| | |
| D1 | Auslenkung, Stellweg |
| D2 | Auslenkung, Stellweg |
| $L_R$ | Abstand zwischen Drehpunkt und Aktuationsstelle |
| L1 | Abstand zwischen dem mittleren Lager und dem beweglichen Ende des Piezo-Biegewandlers, freier Bereich |
| L2 | Abstand zwischen dem mittleren Lager und dem seitlichen Lager |
| $\phi1$ | Verdrehung |
| $\phi2$ | Verdrehung |
| R | Krümmungsradius |

### Patentansprüche

1. Piezoaktuator (1) zur Durchführung einer Stellbewegung (13),

mit einem Piezo-Biegewandler (2) aus einer Trägerschicht (4), die ein- oder zweiseitig mit einer Piezolamelle (3) zumindest teilweise belegt ist, mit einem beweglichen Ende (6), und mit einem Gehäuse (31),

- einen Referenzanschlag (15), der mit dem Gehäuse (31) verbunden ist, zur Festlegung einer Referenzposition (40) für die Stellbewegung (13),
- einen ersten Lagerbereich (7), der Bereiche des Piezoaktuators (1) und des Gehäuses (31) umfasst und welcher Verdrehungen (Φ1) des Piezo-Biegewandlers (2) ermöglicht,
- einen zweiten Lagerbereich (8) mit einer Biegewandler-seitigen Fläche (10) und einer Gehäuse-seitigen Fläche (11) und einer Zwischenschicht (12) zwischen der Biegewandler-seitigen Fläche (10) und der Gehäuse-seitigen Fläche (11), wobei die Zwischenschicht (12) die Biegewandler-seitige Fläche (10) und die Gehäuse-seitigen Fläche (11) verbindet, wobei die Zwischenschicht (12) verflüssigbar ist,

- und ein Andruckelement (24) zur Erzeugung eines Bias-Drehmomentes (34) auf den Piezo-Biegewandler (2) um den ersten Lagerbereich (7) gegen den Referenzanschlag (15),

**dadurch gekennzeichnet, dass** der Piezoaktuator (1) in einem Betriebsmodus und einem Ausrichtungsmodus betreibar ist, wobei im Betriebsmodus der Piezo-Biegewandler (2) Stellbewegungen (13) ausführt, die Temperatur der Zwischenschicht (12) sich unterhalb ihrer Verflüssigungstemperatur befindet und die Zwischenschicht (12) ausreichend fest ist, um die Lagerkräfte im zweiten Lagerbereich (8) zu übertragen, wobei im Ausrichtmodus der Piezo-Biegewandler (2) an einen Referenzanschlag (15) ausgerichtet wird, indem die Temperatur der Zwischenschicht (12) aufgrund von Wärmezufuhr oberhalb ihrer Verflüssigungstemperatur liegt, und wobei bei dem das Verflüssigen der Zwischenschicht (12) im Ausrichtmodus durch eine äußere Wärmequelle (38) erfolgt, oder mit einem integrierten Heizelement (28), das in thermischen Kontakt mit dem zweiten Lagerbereich (8) steht.

2. Piezoaktuator (1) nach Anspruch 1, bei dem das Heizelement (28) durch eine Prozess-Steuerung angesteuert wird und durch die Prozesssteuerung die Heizleistung so bemessbar ist, dass die Temperatur im zweiten Lagerbereich (8) über die Schmelztemperatur der Zwischenschicht (12) angehoben wird, und bei dem durch die Prozesssteuerung die Heizdauer so bemessen wird, dass die Zwischenschicht (12) für eine Zeitdauer in der Größenordnung von 1 Sekunde, 10 Sekunden oder 100 Sekunden geschmolzen wird.

3. Piezoaktuator (1) nach einem der vorhergehenden Ansprüche, bei dem die Zwischenschicht (12) aus einem Lot mit einer Schmelztemperatur unter 150°C, 200°C oder 250°C besteht, wobei mittels des Lots entweder die Trägerschicht (4) des Piezo-Biegewandlers (2) oder eine Elektrode (18) einer Piezolamelle (3) elektrisch kontaktiert wird, oder bei dem die Zwischenschicht (12) aus einem thermoplastischen Kunststoff, einem thermoplastischen Elastomer, einem Bitumen oder einem Wachs besteht, deren Schmelztemperatur unter 100°C, 150°C, 200°C oder 250°C liegt.

4. Piezoaktuator (1) nach Anspruch 3, bei dem

das Bias-Drehmoment (34) aufgebracht wird, indem mittels eines Andruckelementes (24) eine Kraft (F) auf den Piezo-Biegewandler (2) aufgebracht wird,
die Kontaktstelle (23) des Andruckelementes (24) mit dem Piezo-Biegewandler (2) längs des Piezo-Biegewandlers (2) um einen seitlichen Versatz (x) vom Drehpunkt (22) des ersten Lagerbereiches (7) versetzt liegt,
und für die Höhe der Kraft (F) und den Versatz (x) in Abhängigkeit der Klemmkraft ($F_K$) des Piezo-Biegewandlers (2) und des Abstandes (LR) des ersten Lagerbereiches (7) zu einer Aktuationsstelle (14) des Piezo-Biegewandlers (2) gilt:
$(F) * (x) < 0,5 * (F_K) * (L_R)$

5. Piezoaktuator (1) nach einem der vorhergehenden Ansprüche, **dadurch gekennzeichnet, dass** der Piezo-Biegewandler (2) monomorph aufgebaut ist mit einer einzigen Piezolamelle (3), die mit einer Trägerschicht (4) verklebt ist, oder der Piezo-Biegewandler (2) bimorph aufgebaut ist mit zwei Piezolamellen (3), die beidseitig mit der Trägerschicht (4) verklebt sind, wobei die ein oder zwei Piezolamellen (3) die Trägerschicht (4) überwiegend im Bereich einer freien Länge (L1) des Piezo-Biegewandlers (2) bedecken, oder die ein oder zwei Piezolamellen (3) die Trägerschicht (4) im Wesentlichen vollständig bedecken.

6. Verfahren zur Ausrichtung eines Piezoaktuators (1) nach einem der vorhergehenden Ansprüche, mit den folgenden Schritten, in austauschbarer Reihenfolge:

a) das Verflüssigen der Zwischenschicht (12) des zweiten Lagerbereiches (8) durch dessen Beheizung mittels einer Wärmequelle, oder, das Anlegen derjenigen elektrischen Spannungen an alle elektrischen Elektroden des Piezo-Biegewandlers (2), welche mit der Position des Referenzanschlages (15) assoziiert werden sollen,
b) die Ausrichtung des Piezo-Biegewandlers (2) gegen den Referenzanschlag (15) unter der Wirkung des Bias-Drehmomentes (34) während der Dauer einer Ausrichtzeit ($T_A$),
c) Erstarrung der Zwischenschicht (12) durch Abkühlung des zweiten Lagerbereiches (8) während der Dauer einer Abkühlzeit ($T_K$).

7. Verfahren zur Ausrichtung eines Piezoaktuators nach Anspruch 6, wobei die an alle elektrischen Elektroden angelegten elektrischen Spannungen korrigiert werden um die Verformung des Piezo-Biegewandlers unter dem Bias-Drehmomentes zu kompensieren, wenn der Anschlag nicht eine Position im normalen Betrieb darstellt.

8. Verfahren zur Ausrichtung eines Piezoaktuators nach Anspruch 7, **dadurch gekennzeichnet, dass** im Schritt des Anlegens derjenigen elektrischen Spannungen an die elektrischen Elektroden des Piezo-Biegewandlers (2) Spannungen angelegt werden, die sich von den jeweils angelegten Spannungen im zuletzt durchgeführten Ausrichtprozess unterscheiden.

## Claims

1. Piezo actuator (1) for carrying out an actuating movement (13),

   with a piezo bending transducer (2) made of a carrier layer (4) which is at least partially covered on one or two sides with a piezo lamella (3), with a movable end (6),
   and with a housing (31),

      - a reference stop (15) connected to the housing (31) for determining a reference position (40) for the actuating movement (13),
      - a first bearing region (7) which comprises regions of the piezo actuator (1) and the housing (31) and which allows for twists (Φ1) of the piezo bending transducer (2),
      - a second bearing region (8) with a surface (10) on the side of the bending transducer and a surface (11) on the side of the housing, and an intermediate layer (12) between the surface (10) on the side of the bending transducer and the surface (11) on the side of the housing, wherein the intermediate layer (12) connects the surface (10) on the side of the bending transducer and the surface (11) on the side of the housing, wherein the intermediate layer (12) can be liquefied,
      - and a pressure element (24) for generating a bias torque (34) on the piezo bending transducer (2) around the first bearing region (7) against the reference stop (15),

      **characterized in that** the piezo actuator (1) is operable in an operating mode and an alignment mode,
      wherein the piezo bending transducer (2) carries out actuating movements (13) in the operating mode, the temperature of the intermediate layer (12) is below its liquefaction temperature and the intermediate layer (12) is sufficiently firm to transfer the bearing forces in the second bearing region (8),

   and wherein, in the alignment mode, the piezo bending transducer (2) is aligned with a reference stop (15) **in that** the temperature of the intermediate layer (12) is above its liquefaction temperature due to a supply of heat and wherein the intermediate layer (12) is liquefied in the alignment mode by an external heat source (38) or with an integrated heating element (28) which is in thermal contact with the second bearing region (8).

2. Piezo actuator (1) according to claim 1, in which the heating element (28) is controlled by a process controller and the heat output can be assessed by the process controller such that the temperature in the second bearing region (8) is raised above the melting temperature of the intermediate layer (12), and in which the process controller assesses the heating time such that the intermediate layer (12) is melted for a period of time in the order of magnitude of 1 second, 10 seconds, or 100 seconds.

3. Piezo actuator (1) according to any of the preceding claims, in which the intermediate layer (12) consists of a solder with a melting temperature below 150° C, 200° C, or 250° C, wherein, by means of the solder, either the carrier layer (4) of the piezo bending transducer (2) or an electrode (18) of a piezo lamella (3) is electrically contacted, or in which the intermediate layer (12) consists of a thermoplastic material, a thermoplastic elastomer, a bitumen, or a wax, the melting temperature of which is below 100° C, 150° C, 200° C, or 250° C.

4. Piezo actuator (1) according to claim 3, in which

   the bias torque (34) is applied by applying a defined force (F) to the piezo bending transducer (2) by means of a pressure element (24),
   the contact point (23) of the pressure element (24) with the piezo bending transducer (2) is offset along the piezo bending transducer (2) by a lateral offset (x) from the pivot point (22) of the first bearing region (7),
   and for the level of force (F) and the offset (x) on the basis of the clamping force ($F_K$) of the piezo bending transducer (2) and the distance ($L_R$) of the first bearing region (7) to an actuation point (14) of the piezo bending transducer (2), the following applies: (F) * (x) < 0.5 * ($F_k$) * ($L_R$)

5. Piezo actuator (1) according to any of the preceding claims, **characterized in that** the piezo bending transducer (2) is constructed monomorphically with a single piezo lamella (3) which is glued to a carrier layer (4), or the piezo bending transducer (2) is constructed bimorphically with two piezo lamellas (3) which are glued to the carrier layer (4) on both sides, wherein the one or two piezo lamellas (3) cover the carrier layer (4) predominantly in the region of a free length (L1) of the piezo bending transducer (2), or the one or two piezo lamellas (3) cover the carrier layer (4) essentially completely.

6. Method for aligning a piezo actuator (1) according to any of the preceding claims, with the following steps in interchangeable order:

a) the liquefaction of the intermediate layer (12) of the second bearing region (8) by heating it with a heat source, or the application of those electrical voltages to all electrical electrodes of the piezo bending transducer (2) which should be associated with the position of the reference stop (15),
b) the alignment of the piezo bending transducer (2) against the reference stop (15) under the effect of the bias torque (34) for the duration of an alignment time ($T_A$),
c) solidification of the intermediate layer (12) by cooling the second bearing region (8) during a cooling time ($T_K$).

7. Method for aligning a piezo actuator according to claim 6, wherein the electrical voltages applied to all electrical electrodes are corrected in order to compensate for the deformation of the piezo bending transducer under the bias torque, if the stop does not represent a position in normal operation.

8. Method for aligning a piezo actuator according to claim 7, **characterized in that**, in the step of applying said electrical voltages to the electrical electrodes of the piezo bending transducer (2), voltages are applied which differ from the voltages applied in the alignment process carried out most recently.

**Revendications**

1. Piézoactionneur (1) permettant d'effectuer un mouvement de réglage (13),

comportant un transducteur de flexion piézoélectrique (2) constitué d'une couche de support (4) qui est au moins partiellement recouverte d'une lamelle piézoélectrique (3) sur un ou deux côtés, comportant une extrémité mobile (6), et comportant un boîtier (31),

- une butée de référence (15) qui est reliée au boîtier (31) pour définir une position de référence (40) pour le mouvement de réglage (13),
- une première zone d'appui (7) qui comprend des zones du piézoactionneur (1) et du boîtier (31) et qui permet des torsions ($\Phi 1$) du transducteur de flexion piézoélectrique (2),
- une seconde zone d'appui (8) comportant une surface côté transducteur de flexion (10) et une surface côté boîtier (11) et une couche intermédiaire (12) entre la surface côté transducteur de flexion (10) et la surface côté boîtier (11), la couche intermédiaire (12) reliant la surface côté transducteur de flexion (10) et la surface côté boîtier (11), la couche intermédiaire (12) pouvant être liquéfiée,
- et un élément de pression (24) permettant de générer un couple de sollicitation (34) sur le transducteur de flexion piézoélectrique (2) autour de la première zone d'appui (7) contre la butée de référence (15),

**caractérisé en ce que** le piézoactionneur (1) peut être actionné dans un mode de fonctionnement et un mode d'alignement, dans lequel, dans le mode de fonctionnement, le transducteur de flexion piézoélectrique (2) effectue des mouvements de réglage (13), la température de la couche intermédiaire (12) est inférieure à sa température de liquéfaction et la couche intermédiaire (12) est suffisamment fixe pour transmettre les forces d'appui dans la seconde zone d'appui (8), dans lequel, dans le mode d'alignement, le transducteur de flexion piézoélectrique (2) est aligné avec une butée de référence (15), la température de la couche intermédiaire (12) étant supérieure à sa température de liquéfaction en raison d'un apport de chaleur, et dans lequel la liquéfaction de la couche intermédiaire (12) dans le mode d'alignement est effectuée par une source de chaleur externe (38), ou grâce à un élément chauffant (28) intégré en contact thermique avec la seconde zone d'appui (8).

2. Piézoactionneur (1) selon la revendication 1, dans lequel l'élément chauffant (28) est commandé par une commande de processus et la puissance de chauffage peut être mesurée par la commande de processus de telle sorte que la température dans la seconde zone d'appui (8) est élevée au-delà de la température de fusion de la couche intermédiaire (12), et dans lequel la durée de chauffage est mesurée par la commande de processus de telle sorte que la couche intermédiaire (12) est fondue pendant une période de temps de l'ordre de 1 seconde, 10 secondes ou 100 secondes.

3. Piézoactionneur (1) selon l'une des revendications précédentes, dans lequel la couche intermédiaire (12) est constituée d'une soudure présentant une température de fusion inférieure à 150 °C, 200 °C ou 250 °C, dans lequel soit la couche de support (4) du transducteur de flexion piézoélectrique (2), soit une électrode (18) d'une lamelle piézoélectrique (3) est mise en contact électriquement au moyen de la soudure, ou dans lequel la couche intermédiaire (12) est constituée d'un matériau thermoplastique, d'un élastomère thermoplastique, d'un bitume ou d'une cire dont la température de fusion est inférieure à 100 °C, 150 °C, 200 °C ou 250 °C.

4. Piézoactionneur (1) selon la revendication 3, dans lequel

le couple de sollicitation (34) est appliqué par application d'une force (F) au transducteur de flexion piézoélectrique (2) au moyen d'un élément de pression (24),
le point de contact (23) de l'élément de pression (24) avec le transducteur de flexion piézoélectrique (2) est décalé le long du transducteur de flexion piézoélectrique (2) d'un décalage latéral (x) par rapport au point de pivotement (22) de la première zone d'appui (7),
et, pour déterminer l'amplitude de la force (F) et le décalage (x) en fonction de la force de serrage $(F_K)$ du transducteur de flexion piézoélectrique (2) et de la distance $(L_R)$ de la première zone d'appui (7) par rapport à un point d'actionnement (14) du transducteur de flexion piézoélectrique (2), ce qui suit s'applique :

$$(F) * (x) < 0,5 * (F_K) * (L_R).$$

5. Piézoactionneur (1) selon l'une des revendications précédentes, **caractérisé en ce que** le transducteur de flexion piézoélectrique (2) est réalisé de manière monomorphe avec une seule lamelle piézoélectrique (3) collée à une couche de support (4), ou le transducteur de flexion piézoélectrique (2) est réalisé de manière bimorphe avec deux lamelles piézoélectriques (3) collées sur la couche de support (4) des deux côtés, la ou les deux lamelles piézoélectriques (3) recouvrant la couche de support (4) principalement dans la zone d'une longueur libre (L1) du transducteur de flexion piézoélectrique (2), ou la ou les lamelles piézoélectriques (3) recouvrant sensiblement complètement la couche de support (4).

6. Procédé permettant d'aligner un piézoactionneur (1) selon l'une des revendications précédentes, comportant les étapes suivantes, dans un ordre interchangeable :

a) liquéfaction de la couche intermédiaire (12) de la seconde zone d'appui (8) en la chauffant avec une source de chaleur, ou l'application de tensions électriques à toutes les électrodes électriques du transducteur de flexion piézoélectrique (2) qui sont associées à la position de la butée de référence (15),
b) alignement du transducteur de flexion piézoélectrique (2) contre la butée de référence (15) sous l'action du couple de sollicitation (34) pendant la durée d'un temps d'alignement $(T_A)$,
c) solidification de la couche intermédiaire (12) par refroidissement de la seconde zone d'appui (8) pendant la durée d'un temps de refroidissement $(T_K)$.

7. Procédé permettant d'aligner un piézoactionneur selon la revendication 6, dans lequel les tensions électriques appliquées à toutes les électrodes électriques sont corrigées pour compenser la déformation du transducteur de flexion piézoélectrique par le couple de sollicitation lorsque la butée ne constitue pas une position lors du fonctionnement normal.

8. Procédé permettant d'aligner un piézoactionneur selon la revendication 7, **caractérisé en ce que** dans l'étape d'application de tensions électriques aux électrodes électriques du transducteur de flexion piézoélectrique (2), des tensions sont appliquées, lesquelles diffèrent des tensions respectivement appliquées lors du dernier processus d'alignement effectué.

Fig. 1

Fig. 2A

Fig. 2B

Fig. 3A

Fig. 3B

Fig. 3C

Fig. 4A

Fig. 4B

Fig. 5

Fig. 6A

Fig. 6B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2442983 B1
- DE 102009033780 B4

- WO 03016762 A1
- GB 2233766 A